**Europäisches Patentamt**

**European Patent Office**

**Office européen des brevets**

(19)

(11) Numéro de publication: **0 070 209**
**B1**

(12) **FASCICULE DE BREVET EUROPEEN**

(45) Date de publication du fascicule du brevet:
**28.03.84**

(21) Numéro de dépôt: **82401063.1**

(22) Date de dépôt: **11.06.82**

(51) Int. Cl.³: **H 05 K 13/02**

(54) **Dispositif pour le transport de circuits imprimés.**

(30) Priorité: **09.07.81 FR 8113496**

(43) Date de publication de la demande:
**19.01.83 Bulletin 83/3**

(45) Mention de la délivrance du brevet:
**28.03.84 Bulletin 84/13**

(84) Etats contractants désignés:
**BE DE GB IT NL SE**

(56) Documents cités:
**US - A - 3 837 475**
**US - A - 4 261 465**

(73) Titulaire: **Robin, Jean-Claude, 14, Allée de Saint-Cucufa, F-92520 Vaucresson (FR)**

(72) Inventeur: **Ruin, Jean-Pierre, 44, rue Victor Hugo, F-80000 Amiens (FR)**

(74) Mandataire: **Maureau, Bernard, Cabinet Germain, Maureau et Millet Conseils en Brevets d'Invention 64, rue d'Amsterdam, F-75009 Paris (FR)**

ACTORUM AG

Dispositif pour le transport de circuits imprimés

L'invention a pour objet un dispositif pour le transport de circuits imprimés.

Les circuits imprimés consistent en des plaques en résine synthétique dans lesquelles les circuits proprement dits sont noyés au moulage et sur lesquelles apparaissent en relief les divers composants raccordés aux circuits. La présence de ces composants et leurs points de soudure aux circuits rendent l'ensemble fragile, ce qui, compte tenu de leur coût, oblige à les manipuler avec délicatesse et à les présenter dans des conditions telles que, en cours de stockage et en cours de transport, ils ne soient en contact ni les uns avec les autres, ni avec d'autres objets.

Divers moyens sont habituellement utilisés à cette fin. On connaît déjà un dispositif pour le transport de ciructis imprimés (brevet US-A-4 261 465) qui comporte des mallettes ou des bacs dont les parois comportent des rainures intérieures verticales dans lesquelles se glissent les circuits, parallèlement les uns aux autres. Un bac ou une mallette ne pouvant recevoir que des circuits dont au moins l'une des dimensions correspond à la longueur ou à la largeur du contenant, il est aussi connu dudit document de placer dans ce contenant des éléments intercalaires ayant eux-mêmes des parois rainurées et de permettre ainsi de placer dans le même contenant plusieurs circuits ayant des dimensions très différentes. La présence de ces intercalaires est toutefois gênante et même si leur position est réglable, l'utilisation de l'ensemble n'est pas commode et conduit à des pertes de place importantes, si dans le même contenant doivent être présentés des circuits de dimensions très différentes. En outre, les rainures des parois et des intercalaires ne permettent pas une tenue suffisamment sûre des circuits.

Un autre mode de transport et de présentation des circuits imprimés consiste à les placer dans des reliures à soufflets, chaque soufflet recevant un circuit. Cette solution est plus simple que la précédente, mais elle n'est pas satisfaisante, car les circuits ne sont pas tenus dans les soufflets et leurs composants se détériorent fréquemment en raison des chocs d'un soufflet contre l'autre.

Il est certes possible de placer les circuits dans des evneloppes individuelles et de disposer ces enveloppes dans des bacs ou des boîtes, en ayant soin de mettre un produit mousse intercalaire entre les enveloppes. Cette solution manque toutefois de commodité.

Il n'existe donc pas de dispositif permettant de stocker et de transporter des circuits imprimés dans les conditions souhaitées de sécurité et de commodité.

L'invention pallie cette lacune. Elle a pour objet un dispositif qui est du type général des boîtes, bacs ou autres contenants comportant des rainures verticales sur leurs parois intérieures, mais dans lequel ces rainures coopèrent avec des plaques rigides intermédiaires présentant des lumières rectilignes obliques parallèles dans lesquelles peuvent glisser et être immobilisés des coulisseaux comportant chacun au moins une rainure dans laquelle pénètre l'un des bords de la plaque du circuit, quatre tels coulisseaux étant utilisés à la fixation d'une plaque du circuit.

Les coulisseaux, c'est-à-dire les moyens de fixation du circuit sur la plaque pouvant être mobiles et coopérant avec des lumières de cette plaque, il devient possible de fixer sur une même plaque des circuits de dimensions très différentes et même de fixer plusieurs circuits sur la même plaque, avec la certitude néanmoins que les circuits ne seront jamais en contact les uns avec les autres.

Des moyens sont avantageusement prévus pour permettre un blocage rapide des coulisseaux dans la position de réglage souhaitée. Ces moyens peuvent notamment consister en un système à excentrique ou, par exemple à clips.

Dans tous les cas, il est opportun que le blocage s'effectue efficacement dans l'une ou dans l'autre de deux positions orthogonales, suivant que la rainure du coulisseau coopère avec l'un ou avec l'autre de deux bords orthogonaux du circuit.

L'invention sera bien comprise d'ailleurs, et ses avantages ainsi que d'autres caractéristiques ressortiront bien de la description qui suit, en référence au dessin schématique annexé représentant, à titre d'exemple non limitatif, une forme d'exécution de ce dispositif pour le transport de circuits imprimés:

Fig. 1 en est une vue générale en plan par dessus;

Fig. 2 est, à plus grande échelle, une vue de face de la plaque servant de support à un circuit imprimé;

Fig. 3 est, à plus grande échelle, une vue de détail en coupe suivant 3–3 de fig. 2; et

Fig. 4 est une vue par dessous ducoulisseau représenté à la fig. 3.

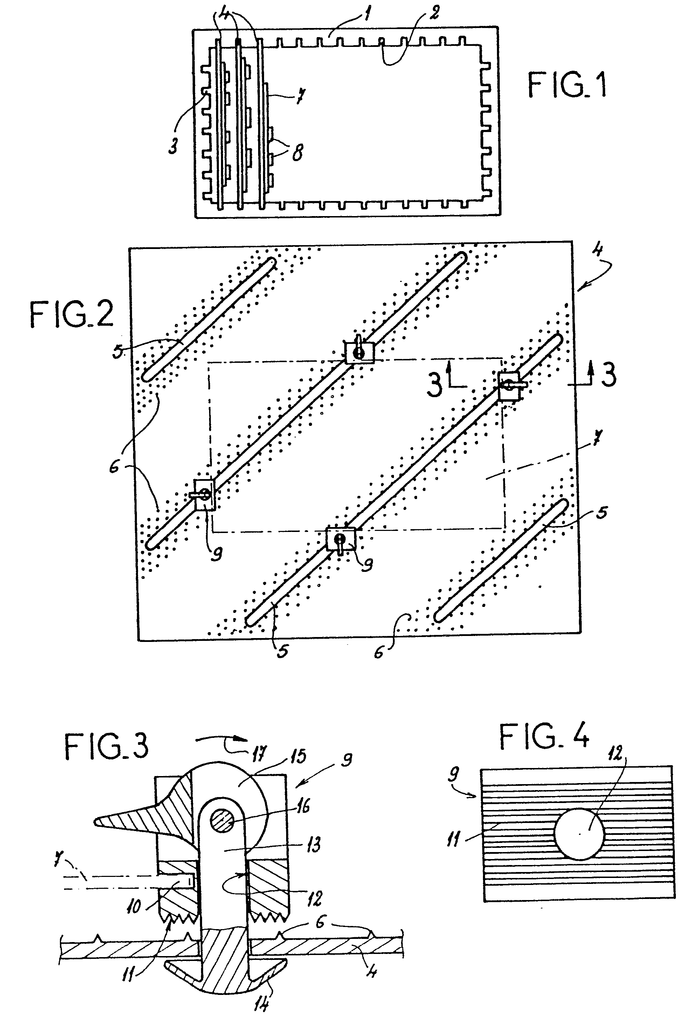

A la fig. 1, 1 désigne un bac ou, de façon générale, un contenant de forme parallélépipédique dont les quatre parois présentent des rainures intérieures verticales. Ces rainures sont désignées par 2 pour celles qui sont aménagées sur les faces longitudinales et par 3 pour celles qui sont aménagées sur les faces transversales.

Ces rainures 2 et 3 sont utilisées, comme cela est connu en soi, pour servir au maintien des circuits imprimés à l'intérieur du bac 1; conformément à l'invention, ce maintien est toutefois réalisé, non pas directement, mais indirectement grâce à des éléments intermédiaires consistant en une pluralité de plaques désignées par 4. Ces plaques, qui sont avantageusement réalisées en matière synthétique, ont une hauteur sensiblement égale à celle des parois du bac; et leur longueur est égale soit à la longueur, soit à la largeur de ce bac. On conçoit dès lors que dans le même bac 1 peuvent être utilisés à volonté deux types de plaques ayant des longueurs différentes.

Dans tous les cas, les plaques 4 présentent des lumières rectilignes obliques désignées par 5. Ces lumières sont par exemple au nombre de quatre; et si tel est le cas, deux de ces lumières sont longues et les deux autres sont relativement courtes.

Sur l'une de ses faces, chaque plaque 4 présente une multitude de picots 6 disposés suivant plusieurs rangées rectilignes tout autour des lumières 5. Ces lumières 5 et les picots 6 constituent les moyens permettant de fixer sur l'une des faces de chaque plaque 4 soit un, soit plusieurs circuits imprimés.

Un circuit cimprimé comportant une plaque, qui est désignée de façon générale par 7 et sur laquelle apparaîssent les divers composants 8, chaque plaque 7 de circuit imprimé est solidarisée avec la plaque intermédiaire 4 au moyen de quatre coulisseaux 9.

Chacun de ces coulisseaux présente une forme générale parallélépipédique et comporte au moins une rainure relativement profonde 10 dans l'une de ses deux faces latérales longitudinales et une pluralité de fines rainures longitudinales 11 dans sa face intérieure; en outre, chaque coulisseau comporte un orifice 12 le traversant de part en part, depuis sa face inférieure jusqu'à sa face supérieure.

La rainure 10 de chaque coulisseau est destinée à coopérer avec la plaque 7 du circuit imprimé, dont l'un des bords pénètre précisément dans cette rainure. Quant aux petites rainures 11, elles sont destinées à coopérer avec les picots 6 de la plaque pour permettre le positionnement du coulisseau 9 dans l'une ou dans l'autre des deux positions orthogonales qu'il doit adopter pour immobiliser la plaque 7 du circuit imprimé sur la plaque 4. Dans l'une de ses positions, le coulisseau est parallèle aux bords transversaux de la plaque 4, alors que dans l'autre position il est parallèle aux bords longitudinaux de cette plaque.

Pour que les petites rainrues 11 de chaque coulisseau 9 viennent et demeurent en prise avec les picots 6 de la plaque, un moyen de pression est utilisé sur chaque coulisseau. Ce moyen est constitué par une tige 13 qui traverse l'orifice 12 du coulisseau et la lumière correspondante 5 de la plaque 4; et cette tige 13 se termine, d'une part, par une embase 14 prenant appui sous la plaque 4 et, d'autre part, par un levier excentrique 15 articulé autour d'un axe 16 sur cette tige 13. Il est dès lors concevable qu'il suffit de donner au levier excentrique 15 un mouvement de déplacement angulaire de 180° dans le sens de la flèche 17 de fig. 3 pour amener les fines rainures 11 du coulisseau 9 en prise avec les picots 6 de la plaque 4. Il est ainsi possible de donner très rapidement et très facilement à quatre coulisseaux 9 les positions nécessaires pour enserrer et immobiliser une plaque 7 de circuit imprimé sur la plaque 4.

Comme il va de soi, l'invention ne se limite pas à la seule forme d'exécution de ce dispositif pour transport de circuits imprimés qui a été ci-dessus décrite à titre d'exemple; elle en embrasse, au contraire, toutes les variantes de réalisation, quels que soient notamment les moyens utilisés pour le transport, ainsi que les moyens adoptés pour immobiliser chacun des coulisseaux 9 sur chaque plaque 4; et elle étend bien entendu son champ d'application au cas où chaque coulisseau 9 présente, non pas une seule rainure 10, mais par exemple deux ou trois telles rainures 10 sur l'une de ses faces latérales principales, afin de permettre de régler l'écartement entre le circuit imprimé et la plaque 4 lui servant de support; et elle étend encore son champ d'application au cas où chaque coulisseau 9 présente une ou plusieurs rainures 10 sur ses deux faces latérales longitudinales principales, afin de permettre au même coulisseau de participer à la fixation de deux ciruits imprimés sur la même plaque, et des moyens peuvent être prévus pour permettre le serrage des plaques 7 de circuits imprimés dans les rainures 10 des coulisseaux 9, ces moyens pouvant d'ailleurs être combinés avec ceux d'immobilisation de ces coulisseaux sur les plaques intermédiaires 4.

**Revendications**

1. Dispositif pour le transport de circuits imprimés, du type de ceux comportant une boîte, une plaque ou autre contenant, dont les parois intérieures présentent des rainures verticales, caractérisé en ce que ses rainures (2) coopèrent avec des plaques rigides intermédiaires (4) présentant des lumières rectilignes obliques parallèles (5) dans lesquelles peuvent glisser et être immobilisés des coulisseaux (9) comportant chacun au moins une rainure (10) dans laquelle pénètre l'un des bords de la plaque du circuit (7), quatre tels coulisseaux (9) étant utilisés à la fixation d'une plaque du circuit (7).

2. Dispositif selon la revendication 1, caractérisé en ce que des moyens de blocage (13, 14, 15) sont prévus pour bloquer les coulisseaux (9) dans la position d'immobilisation souhaitée sur la plaque (4).

3. Dispositif selon la revendication 2, caractérisé en ce que chaque moyen de blocage comporte respectivement une tige (13) traversant librement un des coulisseaux (9) et aussi une des lumières (5) de la plaque (4), laquelle tige se termine, d'une part, par une embase (14) prenant appui sous la plaque (4) et d'autre part par un levier excentrique articulé (15) prenant appui sur le coulisseau.

4. Dispositif selon l'une quelconque des revendications 1 à 3, caractérisé en ce que des moyens sont prévus pour permettre à chaque coulisseau (9) d'être bloqué dans l'une ou dans l'autre de deux positions orthogonales, suivant que sa rainure (10) coopère avec l'un ou avec l'autre de deux bords orthogonaux du circuit imprimé (7).

5. Dispositif selon la revendication 4, caractérisé en ce que pour le blocage dans lesdites deux positions orthogonales chaque coulisseau présente, sur sa face en contact avec la plaque (4), une pluralité de fines rainures longitudinales (11) coopérant avec une multitude de picots (6) disposés suivant des rangées rectilignes autour des lumières (5), sur la face de la plaque (4) avec laquelle les coulisseaux (9) sont appelés à venir en contact.

**Patentansprüche**

1. Vorrichtung zum Transportieren von gedruckten Schaltungen mit Hilfe eines Kastens, eines Einsatzes oder anderer Behältnisse, deren Innenwände mit vertikal verlaufenden Nuten versehen sind, dadurch gekennzeichnet, dass die Nuten (2) der Behälter mit starren Zwischenplatten (4) zusammenwirken, die mit schräg und zueinander parallel verlaufenden Schlitzen (5) versehen sind, in denen sich Gleitstücke (9) verschieben und festlegen lassen, die jeweils mit mindestens einer Nut (10) versehen sind, in die der eine Rand der Schaltungsplatte (7) eingreift, und dass vier derartige Gleitstücke (9) zum Befestigen einer Schaltungsplatte (7) benutzt werden.

2. Vorrichtung nach Anspruch 1, dadurch gekennzeichnet, dass Klemmeinrichtungen (13, 14, 15) vorgesehen sind, die die Gleitstücke (9) in der verlangten Festlegungsposition auf der Platte (4) festklemmen.

3. Vorrichtung nach Anspruch 2, dadurch gekennzeichnet, dass jede Klemmeinrichtung jeweils eine Stange (13) aufweist, die jeweils ein Gleitstück (9) sowie einen der Schlitze (5) der Platte (4) leichtgängig durchsetzt und die einerseits in ein Fusstück (14), das sich unter der Platte (4) abstützt, und andererseits in einen exzentrisch gelagerten Hebel (15) ausläuft, der sich an dem Gleitstück (9) abstützt.

4. Vorrichtung nach einem der Ansprüche 1 bis 3, dadurch gekennzeichnet, dass eine Einrichtung vorgesehen ist, die es gestattet, jedes Gleitstück (9) in jeweils einer von zwei orthogonalen Stellungen festzuklemmen, je nachdem, ob die in dem Gleitstück befindliche Nut (10) mit dem einen oder dem anderen der beiden orthogonalen Ränder der gedruckten Schaltung (7) zusammenarbeitet.

5. Vorrichtung nach Anspruch 4, dadurch gekennzeichnet, dass für das Festklemmen in den beiden erwähnten orthogonalen Stellungen an jedem Gleitstück (9) an der die Platte (4) berührenden Seite eine Anzahl feiner Längsrillen (11) vorgesehen ist, die mit einer Vielzahl von kleinen Stacheln (6) zusammenwirken, die in geradliniger Aneinanderreihung um die Schlitze (5) auf derjenigen Seite der Platte (4) angeordnet sind, mit der die Gleitstücke (9) in Kontakt treten sollen.

**Claims**

1. Apparatus for transporting printed circuits, of the type comprising a box, a plate or other container, whose internal walls present vertical grooves, characterised in that its grooves (2) cooperate with rigid intermediate plates (4) presenting oblique parallel rectilinear apertures (5) in which may be slidable and locked in position sliders (9) each comprising at least one groove (10) in which one of the edges of the circuit board (7) penetrates, four such sliders (9) being used for fixing a circuit board (7).

2. A device according to claim 1, characterised in that locking means (13, 14, 15) are provided for locking the sliders (9) in the desired fixed position on the plate (4).

3. A device according to claim 2, characterised in that each locking means comprises respectively a bar (13) freely passing through one of the sliders (9) and also one of the apertures (5) of the plate (4), this rod terminating, on the one hand, at a member (14) bearing underneath the plate (4) and on the other hand by an eccentric articulated lever (15) bearing on the slider.

4. A device according to any one of claims 1 to 3, characterised in that means are provided for permitting each slider (9) to be locked in one or the other of two orthogonal positions in which its groove (10) co-operates with one or the other of two orthogonal edges of the printed circuit (7).

5. A device according to claim 4, characterised in that for locking it in said two orthogonal positions each slider presents, on its face in contact with the plate (4), a plurality of narrow longitudinal grooves (11) co-operating with a plurality of projections (6) disposed in rectilinear arrays along the apertures (5) on the face of the plate (4) with which the sliders (9) are intended to come into contact.

FIG.1

FIG.2

FIG.3

FIG. 4